# FASCICULE DE BREVET EUROPEEN

(11) **EP 4 030 432 B1**
(45) Date de publication et mention de la délivrance du brevet: **13.11.2024**
(21) Numéro de dépôt: 22151290.8
(22) Date de dépôt: 13.01.2022
(51) Int. Cl.: G11C 13/00

(54) **MATRICE DE COMMUTATEURS ELEMENTAIRES FORMANT UN MESSAGE, PROCEDES D' ECRITURE ET DE LECTURE ASSOCIES**
MATRIX AUS ELEMENTAREN SWITCHES, DIE EINE NACHRICHT BILDEN, UND ENTSPRECHENDE SCHREIB- UND LESEVERFAHREN
ARRAY OF BASIC SWITCHES FORMING A MESSAGE, ASSOCIATED WRITING AND READING METHODS

(30) Priorité: 14.01.2021 FR 2100321
(43) Date de publication de la demande: 20.07.2022
(73) Titulaire: Commissariat à l'Energie Atomique et aux Energies Alternatives, 75015 Paris (FR)
(72) Inventeur: GRENOUILLET, Laurent, 38054 Grenoble Cedex 09 (FR); VERDY, Anthonin, 38054 Grenoble Cedex 09 (FR)
(74) Mandataire: Cabinet Camus Lebkiri

(56) Documents cités:
- EP-A1- 2 765 577
- WO-A2-2020/049363
- US-A1- 2019 198 096

## Description

### DOMAINE TECHNIQUE DE L'INVENTION

Le domaine technique de l'invention est celui des matrices de commutateurs élémentaires destinées à former un message aléatoire ou prédéterminé comportant une pluralité de commutateurs résistifs. La présente invention concerne également un procédé d'écriture ou de programmation et un procédé de lecture de la matrice. Les applications visées sont notamment mais non limitativement celles de la cybersécurité telles que la sécurité des composants électroniques, la sécurité des composants loT (« Internet of Things »), la lutte contre la contrefaçon de puces électroniques, l'authentification de puces électroniques et des données, le stockage d'informations confidentielles (stockage de clefs ou de messages chiffrés par exemple), l'inscription de codes. Toutes ces applications nécessitent un niveau de confidentialité important.

### ARRIERE-PLAN TECHNOLOGIQUE DE L'INVENTION

Les applications nécessitant de discriminer entre un dispositif légitime et un dispositif contrefait sont de plus en plus nombreuses, notamment dans le domaine de la cybersécurité. C'est le cas par exemple des objets connectés loT qui doivent être de plus en plus sécurisés afin d'éviter le clonage. C'est aussi le cas d'autres produits plus usuels dont on veut s'assurer l'authenticité allant d'étiquettes inviolables de médicaments ou de bouteilles de vin à des dispositifs électroniques.

Une solution connue à cette exigence de sécurité consiste à utiliser un mécanisme de défi chalenge-réponse qui permet de réaliser une authentification en se protégeant d'une attaque par émulation (rejeu ou répétition de défis différents permettant d'accéder à la fonction). Cette technique appelée fonctions physiques inviolables ou PUF pour « Physical Unclonable Functions » repose sur une micro-puce inviolable qui permet de sécuriser les objets sous la forme d'une étiquette ou d'être directement intégrée dans un autre dispositif lors de la fabrication. Le dispositif PUF comporte un code ou fonction qui lui est propre, comme une « empreinte digitale » qui diffère pour chaque être humain. Cette fonction doit être quasiment unique pour chaque dispositif (on parle de forte variabilité inter-chip ou entre chaque puce) et donner quasiment la même réponse lorsque le défi ou chalenge lui est appliqué plusieurs fois (on parle de faible variabilité intra-chip ou au sein d'une même puce). Un utilisateur d'un dispositif peut demander au fabricant un défi (ou un couple défi-réponse). Le défi C est appliqué au dispositif ; l'utilisateur calcule alors la réponse R au défi C via la fonction F présente dans le dispositif et compare cette dernière à la réponse attendue. Cette opération peut être répétée plusieurs fois et on obtient à chaque fois la même réponse R. La fonction F propre à chaque dispositif est obtenue lors du procédé de fabrication ou de sécurisation de la puce (ou circuit intégré) associée au dispositif via des étapes d'implémentations physiques aléatoires introduisant des caractéristiques discernables assurant l'unicité de la puce.

Une implémentation connue de la technologie PUF est décrite dans la publication « Error free Physically Unclonable Function (PUF) with programmed ReRAM using reliable résistance states by Novel ID-Generation method » (Tseng et al. - international Conférence on Solid State Devices and Materials 2017). Celle-ci est basée sur l'utilisation d'une matrice de mémoires résistives non volatiles réinscriptibles ReRAM telles que des mémoires OxRAM comportant une zone active à oxydes métalliques (« Oxide Résistive RAM »). Ces mémoires sont des mémoires de type résistives, c'est-à-dire qu'elles peuvent présenter au moins deux états résistifs, correspondant à un état fortement résistif (état « HRS » pour « High Résistance State ») et à un état faiblement résistif (état « LRS » pour « Low Résistance State »), sous l'application d'une tension.

Les mémoires résistives ont besoin de deux électrodes supérieure et inférieure pour fonctionner. Par exemple, les mémoires OxRAM présentent une structure M-I-M (Métal-Isolant-Métal) comprenant un matériau actif de résistance électrique variable, en général un oxyde de métal de transition (ex. WO3, HfO2, Ta2O5, TiO2...), disposé entre deux électrodes métalliques. Le passage de l'état « HRS » à l'état « LRS » est gouverné par la formation et la rupture d'un filament conducteur entre les deux électrodes. En modifiant les potentiels appliqués aux électrodes, il est possible de modifier la répartition du filament, et de modifier ainsi la conduction électrique entre les deux électrodes. Dans la couche active, le filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé aboutissant à l'état LRS, et de RESET aboutissant à l'état HRS, lorsque le filament est rompu à nouveau par application respective d'une tension de SET, VSET ou de RESET, VRESET aux bornes des électrodes). La fabrication d'une mémoire filamentaire comprend une étape dite de « forming », au cours de laquelle le filament est formé pour la première fois dans la couche active, initialement dépourvue de filament. La couche active est en effet initialement complètement isolante électriquement. Lors de l'étape de « forming » initial, un filament électriquement conducteur est formé dans la couche active, en réalisant une sorte de claquage contrôlé de cette couche. Le filament ainsi formé s'étend alors de part en part à travers la couche active, en reliant électriquement l'électrode inférieure et l'électrode supérieure. Pour réaliser cette étape de forming, on peut par exemple appliquer une tension électrique entre l'électrode inférieure et l'électrode supérieure de la cellule mémoire considérée, puis augmenter progressivement la valeur de cette tension jusqu'à une tension seuil, appelée tension de forming Vforming, au-delà de laquelle un claquage de la couche active est obtenu. Après cette étape de « forming », la cellule mémoire est prête à l'usage. Le filament conducteur peut alors être rompu, puis reformé, puis rompu à nouveau et ainsi de suite, à une valeur de tension inférieure à la tension de forming Vforming.

Les mémoires résistives OxRAM présentent notamment l'intérêt de pouvoir s'intégrer avec de fortes densités, via une intégration de type matricielle « cross-bar ».

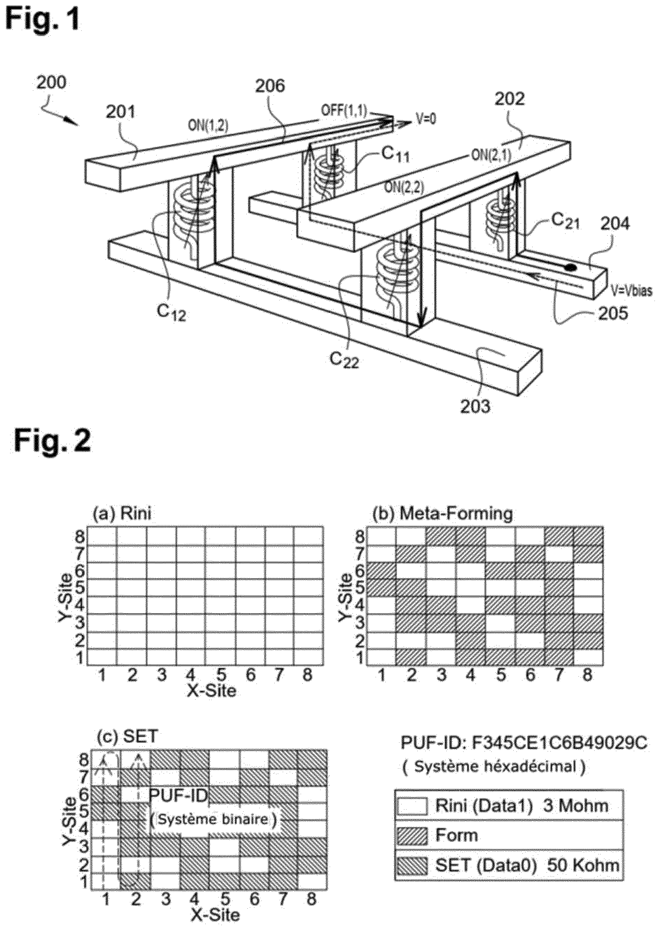

Une telle architecture 200 est illustrée sur la figure 1 et comporte une pluralité de lignes d'accès 201, 202, 203, 204 et une pluralité de cellules mémoires (ici quatre cellules C11, C21, C22, C12) non volatiles réinscriptibles basées sur des matériaux actifs (par exemple des cellules OxRAM). Les lignes d'accès sont formées par des lignes de bits 201, 202 parallèles supérieures et des lignes de mots 203, 204 inférieures perpendiculaires aux lignes de bits, les cellules élémentaires C11, C21, C22, C12 étant prises en sandwich à l'intersection entre les lignes de bits 201, 202 et les lignes de mots 203, 204. L'architecture 200 forme ainsi un réseau où chaque cellule mémoire est adressable individuellement, en sélectionnant la bonne ligne de bits et la bonne ligne de mots.

Une telle architecture permet de mettre en oeuvre la technologie PUF en faisant passer aléatoirement une partie des cellules OxRAM à l'état SET et en laissant l'autre partie à l'état pristine (c'est-à-dire que ces cellules n'ont pas subi l'étape de forming initiale).

Les différentes étapes (a), (b) et (c) permettant cette mise en oeuvre sont illustrées à la figure 2. Une matrice de 64 (8 lignes et 8 colonnes) cellules non volatiles, de type OxRAM, est représentée. Lors de l'étape (a), toutes les cellules sont à l'état pristine : elles ne sont donc pas formées et possèdent une résistance pristine Rini très élevées (i.e. supérieure à 3 Mohm). Lors de l'étape (b), on réalise une étape de « forming » aléatoire (désignée par le terme Meta-forming), c'est-à-dire que l'on forme sensiblement la moitié des cellules par application d'une tension de forming adaptée. Pour cela, une tension de forming correspondant à la médiane de la distribution des tensions de forming de ce type de cellules OxRAM, est appliquée à l'ensemble de la matrice. Lors de cette étape (b), la moitié des cellules voient leur résistance baisser par la première formation d'un filament conducteur. Enfin, lors de l'étape (c), l'étape (b) est confortée par l'application d'une tension de SET, permettant de faire passer les cellules formées à l'étape (b) à un état faiblement résistif LRS avec une résistance inférieure à 50 kOhms. A la fin de cette étape (c), la matrice possède un code aléatoire correspondant à la répartition aléatoire entre les cellules à l'état SET et les cellules à l'état pristine. Il est alors possible de lire le code en appliquant une tension de lecture, bien inférieure aux tensions de forming et de SET, typiquement de l'ordre de 0,1 à 0,5V, intervalle de tensions relativement large.

La solution exposée ci-dessus est simple à mettre en oeuvre mais n'assure cependant pas une sécurité optimale. En effet, un utilisateur indésirable connaissant le principe de fonctionnement des cellules OxRAM, connait l'ordre de grandeurs des tensions de lecture et pourra obtenir le code.

Le même type de problématique se pose dans le cas d'applications OTP (« One Time Programmable ») en contrôle d'intégrité de type CRC (Contrôle de Redondance Cyclique ou « Cyclic redundancy check » selon la terminologie anglaise) ou en flag de sécurité pour détecter une intrusion ou un événement non souhaité dans la programmation d'une puce. Le CRC est un code prédéterminé de détection d'erreur couramment utilisé dans les réseaux numériques et les dispositifs de stockages mémoires afin de détecter d'éventuelles modifications accidentelles survenues durant un transfert de données. Ce code doit être connu et non facilement accessible.

Le document EP 2765577 A1 divulgue une méthode de programmation d'une matrice de mémoires résistives non-volatiles.

Le document US 2019/198096 A1 divulgue une matrice de points mémoires dans laquelle chaque point mémoire comprend un commutateur.

Le document WO 2020/049363 A2 divulgue une matrice de mémoires volatiles.

### RESUME DE L'INVENTION

L'invention offre une solution aux problèmes évoqués précédemment, en proposant notamment une matrice de commutateurs élémentaires résistifs destinée à former un message aléatoire ou prédéterminé avec un degré de sécurité et de confidentialité supérieur aux solutions existantes, notamment à base d'OxRAM.

Plus précisément, l'invention a pour objet une matrice selon la revendication 1 comprenant une pluralité de commutateurs volatils, chacun desdits commutateurs volatils comportant une couche active réalisée dans un matériau OTS, la pluralité de commutateurs volatils étant divisée en deux groupes de manière à former un message.

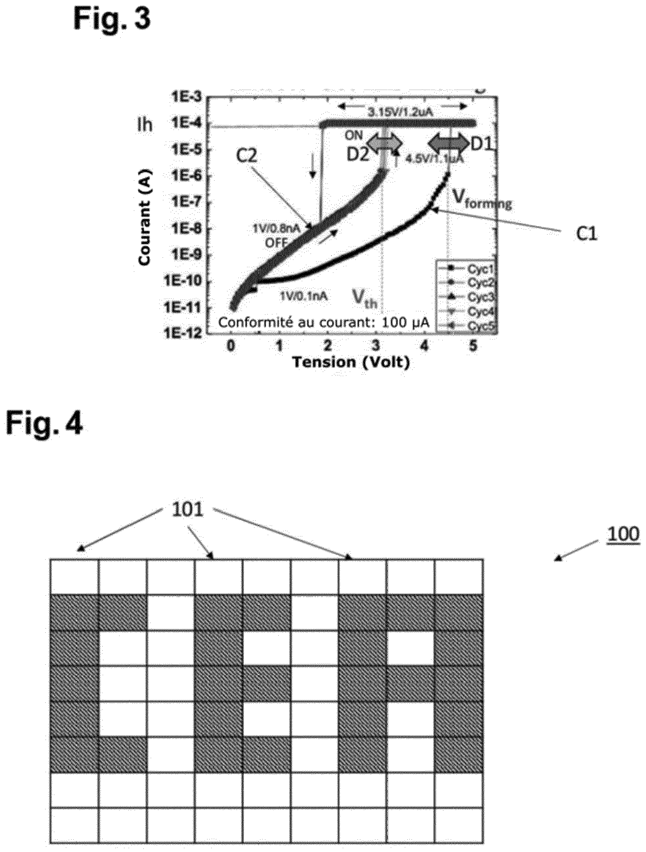

On entend par matériau OTS un matériau dit « Ovonic Threshold Switching ». Le matériau actif OTS est un alliage chalcogénure choisi pour assurer le fonctionnement d'un commutateur volatil résistif selon le principe représenté à la figure 3 qui représente la caractéristique courant tension d'un commutateur OTS au moment de l'initialisation ou forming, c'est-à-dire lors de la première utilisation (courbe C1) et après l'initialisation ou le forming (courbe C2). Après le forming, selon la courbe C2, le commutateur est très résistif dans l'état OFF. Dès qu'on applique au commutateur une tension supérieure à une tension de seuil Vth, le courant augmente rapidement pour atteindre l'état ON du dispositif, un état bassement résistif. Dès que le courant ou la tension est réduit au-dessous d'une valeur spécifique dite de maintien ou de « holding » Ih, le dispositif redevient OFF, d'où le caractère volatil du commutateur. Avant de pouvoir fonctionner dans son mode nominal (c'est-à-dire être en mesure de passer d'un état ON à un état OFF et vice versa), le commutateur doit être tout d'abord initialisé (courbe C1), l'initialisation consistant à appliquer une tension d'initialisation (dite également tension de forming) Vforming aux bornes de le commutateur à initialiser. L'application de cette tension de forming ou d'initialisation permet de rendre conductrice la zone active OTS initialement très résistive. Il est également à noter que la résistance de l'état ON est indépendante de l'état initialisé ou non du commutateur. On ne peut avoir aucune information sur l'état du commutateur (vierge ou initialisé) en mesurant la résistance de l'état ON. On notera que les matériaux OTS ont par ailleurs la particularité de présenter des courants de fuite très bas à l'état OFF et un ratio entre le courant à l'état ON et le courant à l'état OFF élevé permettant de bien distinguer ces deux états.

Grâce à l'invention, on utilise avantageusement l'aspect non volatil de l'initialisation ou du forming d'un matériau OTS utilisé dans un commutateur ayant un caractère volatil sur le plan résistif. Dit autrement et comme expliqué plus haut, un commutateur OTS perd son état bassement résistif lorsque le courant ou tension est réduit sous sa valeur de maintien donc perd son état bassement résistif en l'absence d'alimentation : la commutateur OTS est donc bien volatil sur le plan résistif. En revanche, une fois formé, le commutateur garde l'opération de forming « en mémoire » même s'il redevient hautement résistif une fois l'opération de forming terminée et en l'absence d'une tension de seuil appliquée à ses bornes, l'opération de forming étant réalisée une fois pour toute, d'où le côté non volatil du forming.

La matrice possédant seulement une partie de ses commutateurs formés, repose sur le principe de fonctionnement suivant : le code contenu dans la matrice est représenté par l'identification des commutateurs formés et non formés. Contrairement aux matrices faites de cellules OxRAM de l'état de l'art, la matrice selon l'invention ne comporte, en l'absence de tension appliquée à ses bornes, que des commutateurs hautement résistifs, qu'elles soient ou non formées. Ainsi, si on cherche à lire le code caché dans la matrice, il convient de trouver la bonne tension de lecture sans détruire le code, rendant l'accès au code beaucoup plus difficile que dans les matrices connues. En effet, si on applique une tension de lecture trop faible (i.e. en-dessous des tensions de seuil des commutateurs OTS), tous les commutateurs resteront dans l'état hautement résistif et il ne sera pas possible d'accéder au code. C'est pourtant intuitivement ce que cherchera à faire l'homme du métier car les tensions de lecture utilisées pour la lecture de commutateurs résistifs sont généralement beaucoup plus basses que les tensions de seuil et d'initialisation de ces commutateurs. La tension de seuil d'un commutateur OTS est inférieure ou égale à sa tension de forming. Ainsi, si à l'inverse, on utilise une tension de lecture trop élevée supérieure à la tension de forming, on risque de former certains commutateurs initialement non formés, et donc de modifier le code présent dans la matrice. On comprend que la tension de lecture doit être choisie minutieusement et que cette dernière dépend des caractéristiques des commutateurs OTS présents dans la matrice, seules connues du fabricant, telles que la forme, la taille, l'épaisseur de la couche et le matériau de la couche active et des électrodes situées de part et d'autre de la couche active. Pour être lu correctement, il convient donc d'utiliser une tension de lecture comprise entre la tension de seuil et la tension de forming ; compte tenu de la dispersion des tensions de seuil et tensions de forming liée à la pluralité de commutateurs présentes dans la matrice (même en cas de commutateurs identiques structurellement), la tension de lecture utilisée devra se trouver entre la tension maximale de la distribution des tensions de seuil des commutateurs présentes dans la matrice et la tension minimale de la distribution des tensions d'initialisation des commutateurs présentes dans la matrice. On notera que l'utilisation d'une telle tension de lecture est totalement contrintuitive par rapport aux valeurs classiques des tensions de lecture des cellules résistives connues de l'état de l'art qui sont beaucoup plus faibles. La matrice selon l'invention offre donc une sécurité accrue par rapport aux matrices connues de l'état de la technique utilisant des mémoires résistives non volatiles. La lecture d'un commutateur OTS (c'est-à-dire le fait de discriminer entre un état OFF et un état ON de la commutateur) est de plus facilitée par le rapport important existant entre l'intensité du courant à l'état ON traversant la commutateur et l'intensité du courant à l'état OFF.

Un parallèle amusant peut être fait entre la matrice selon l'invention et l'exemple de l'écriture d'un message sur une feuille de papier avec du jus de citron. Une fois le jus de citron sec, pour lire le message, il faut approcher la flamme d'un briquet : si la flamme est trop éloignée on ne voit rien. Si la flamme est à bonne distance le message apparait. Si la flamme est trop proche, la feuille prend feu le message est détruit. La matrice selon l'invention permet de « fabriquer de l'encre magique » à l'échelle nanométrique grâce à l'utilisation de commutateurs OTS correctement programmés. Le jus de citron sur la feuille de papier, c'est le message écrit par les commutateurs OTS qui ont été formés dans la matrice. L'équivalent d'une « flamme trop éloignée qui fait qu'on ne voit pas le message », consiste à lire la matrice avec une tension de lecture inférieure à la tension de seuil. L'équivalent d'une « flamme à bonne distance qui fait que le message apparaît » consiste à lire la matrice avec une tension de lecture comprise entre la tension maximale de la distribution des tensions de seuil des commutateurs présents dans la matrice et la tension minimale de la distribution des tensions d'initialisation des commutateurs présents dans la matrice. L'équivalent d'une « flamme trop proche qui fait que la feuille prend feu et que le message est détruit » consiste à lire la matrice avec une tension de lecture supérieure à la tension de forming d'au moins un des commutateurs non formés.

Dit autrement, la matrice selon l'invention consiste en une pluralité de commutateurs volatils comportant chacun une couche active OTS, les commutateurs n'étant en série avec aucun autre dispositif, notamment du type mémoire. Partant de cette matrice faite exclusivement de commutateurs OTS, il est alors possible d'écrire un message aléatoire ou prédéterminé en divisant la pluralité de commutateurs en deux groupes, un premier dans lequel chacun des commutateurs volatils du premier groupe a été préalablement initialisé au moyen d'une tension d'initialisation et un second groupe dans lequel aucun des commutateurs volatils du deuxième groupe n'a été préalablement initialisé. Cette matrice consistant une pluralité de commutateurs volatils du type OTS non encore initialisés et sans autres composants présents dans la matrice, est également couverte par la présente invention.

Outre les caractéristiques qui viennent d'être évoquées dans le paragraphe précédent, la matrice selon l'invention peut présenter une ou plusieurs caractéristiques complémentaires parmi les suivantes, considérées individuellement ou selon toutes les combinaisons techniquement possibles :
- tous les commutateurs volatils de la matrice sont structurellement identiques ;
- chaque commutateur comprend une première électrode, une deuxième électrode, la couche active étant localisée entre la première électrode et la deuxième électrode ;
- la première électrode comporte une couche de carbone en contact avec la couche active ;
- la pluralité de commutateurs est choisie de sorte que la distribution des tensions de seuil des commutateurs présents dans la matrice et la distribution des tensions d'initialisation des commutateurs présents dans la matrice ne présentent aucune tension commune ;
- la pluralité de commutateurs est choisie de sorte que la caractéristique courant-tension de chaque commutateur soit identique en-dessous de sa tension de seuil que le commutateur soit ou non initialisé ;
- la tension de lecture utilisée pour lire le message se trouve entre la tension maximale de la distribution des tensions de seuil des commutateurs présents dans la matrice et la tension minimale de la distribution des tensions d'initialisation des commutateurs présents dans la matrice ; la tension de lecture est typiquement entre 2V et 5V.
- ledit message est un message aléatoire ou prédéterminé.

L'invention a également pour objet un procédé d'écriture d'un message dans une matrice comprenant une pluralité de commutateurs volatils selon l'objet de la revendication indépendante 9.

Outre les caractéristiques qui viennent d'être évoquées dans le paragraphe précédent, le procédé d'écriture selon l'invention peut présenter une ou plusieurs caractéristiques complémentaires parmi les suivantes, considérées individuellement ou selon toutes les combinaisons techniquement possibles :
- ledit message est un message prédéterminé, le procédé comportant les étapes suivantes :
   - sélection des commutateurs formant le premier groupe ;
   - application d'une tension d'initialisation sur chacun des commutateurs du premier groupe de manière à initialiser chacun d'entre eux, sans appliquer de tension d'initialisation sur les autres commutateurs formant le second groupe ;
- ledit message est un message aléatoire, le procédé comportant une étape d'application d'une tension à chacun des commutateurs de la pluralité de commutateurs, la valeur de la tension étant choisie pour initialiser un pourcentage donné et différent de 100% de commutateurs parmi la pluralité de commutateurs ;
- la valeur de la tension appliquée correspond sensiblement à la valeur médiane de la distribution des tensions d'initialisation de la pluralité de commutateurs.

L'invention a également pour objet un procédé de lecture du message présent dans une matrice selon l'invention comportant une étape d'application d'une tension de lecture à chacun des commutateurs, ladite tension de lecture étant comprise entre la tension maximale de la distribution des tensions de seuil des commutateurs présents dans la matrice et la tension minimale de la distribution des tensions d'initialisation des commutateurs présents dans la matrice

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 représente une architecture d'adressage d'une pluralité de cellules mémoires selon l'état de la technique ;
- La figure 2 illustre les étapes d'écriture d'un code dans une matrice de cellules OxRAM selon l'état de la technique ;
- La figure 3 illustre le principe de fonctionnement courant tension d'un commutateur comportant une couche active OTS ;
- La figure 4 montre une représentation schématique d'une matrice selon l'invention ;
- La figure 5 montre une représentation schématique d'une matrice avant initialisation des commutateurs OTS ;
- La figure 6 montre une représentation schématique d'un commutateur OTS utilisé dans la matrice selon l'invention ;
- La figure 7 représente les étapes du procédé d'écriture pour l'obtention d'une matrice selon l'invention ;
- La figure 8 montre une représentation schématique d'une matrice selon un second mode de réalisation de l'invention ;
- La figure 9 représente une pluralité de caractéristiques courant tension correspondant à plusieurs commutateurs OTS au moment de l'initialisation ou forming ;
- Les figures 10 à 13 illustrent le procédé de lecture d'une matrice selon l'invention ;
- La figure 14 représente différentes distributions de caractéristiques courant tension avant et après initialisation pour des commutateurs OTS réalisés avec le même matériau ;
- La figure 15 représente un autre exemple de commutateur utilisable dans la matrice selon l'invention ;
- La figure 16 représente la distribution cumulée en fonction de la tension de seuil et d'initialisation pour les deux types de commutateurs des figures 6 et 15.
- La figure 17 montre la distribution cumulée en fonction de la tension de seuil et d'initialisation pour trois matériaux différents utilisés pour la couche active OTS.

### DESCRIPTION DETAILLEE D'AU MOINS UN MODE DE REALISATION DE L'INVENTION

Sauf précision contraire, un même élément apparaissant sur des figures différentes présente une référence unique.

Les figures 1 et 2 ont déjà été décrites en référence à l'état de la technique et la figure 3 a été décrite pour présenter le fonctionnement général de l'invention.

La figure 4 représente une matrice 100 selon l'invention. Cette matrice comporte une pluralité de commutateurs élémentaires OTS « Ovonic Threshold Switching » 101 : ici la matrice comporte 72 (9 colonnes et 8 lignes) commutateurs, étant entendu que la matrice peut comporter un nombre identique ou différent de colonnes et lignes. Ces commutateurs sont ici tous identiques d'un point de vue structurel c'est-à-dire qu'ils sont réalisés en utilisant les mêmes matériaux, la même géométrie et qu'ils ont toutes les mêmes dimensions. Les commutateurs pourraient ne pas être toutes identiques même si le fait d'avoir des commutateurs identiques présente un avantage en termes de simplicité de fabrication et d'utilisation. La matrice 100 peut comporter une pluralité de lignes d'accès supérieures et inférieures non représentées ici et bien connues de l'homme du métier (cf. par exemple figure 1), les commutateurs élémentaires 101 étant pris en sandwich à l'intersection entre les lignes supérieures, et les lignes inférieures, qui permettront l'écriture et la lecture des commutateurs ainsi que leur initialisation. L'architecture forme ainsi un réseau où chaque commutateur est adressable individuellement, en sélectionnant la bonne ligne supérieure et la bonne ligne inférieure.

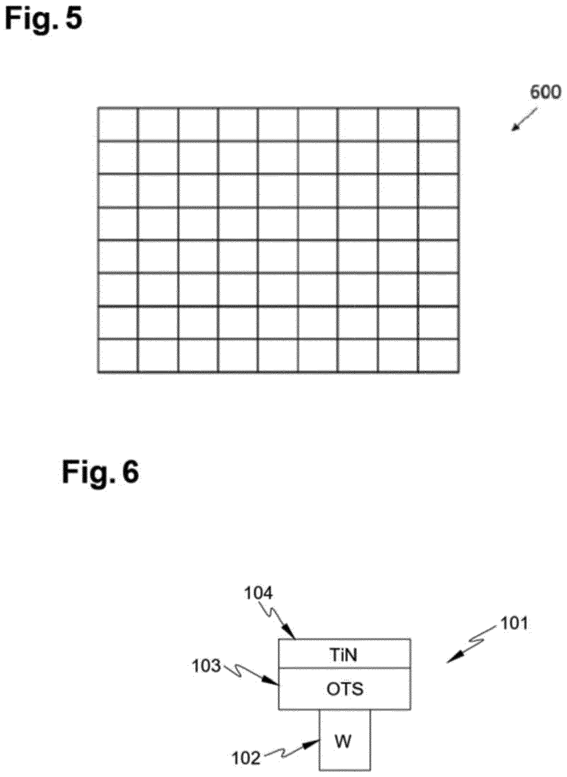

Un exemple de commutateur 101 est représenté en figure 6. Le commutateur 101 comporte :
- une couche de matériau conducteur formant une électrode inférieure 102 ;
- une couche active réalisée dans un matériau actif OTS103 ;
- une couche de matériau conducteur, formant une électrode supérieure 104.

On définit une électrode supérieure d'un dispositif comme l'électrode située au-dessus de ce dispositif et l'électrode inférieure d'un dispositif comme l'électrode située en dessous de ce dispositif, les électrodes étant situées de part et d'autre du dispositif. Bien entendu, les adjectifs « supérieure » et « inférieure » sont ici relatifs à l'orientation de l'ensemble incluant l'électrode supérieure, le dispositif et l'électrode inférieure si bien qu'en retournant cet ensemble, l'électrode précédemment qualifiée de supérieure devient l'électrode inférieure et l'électrode précédemment qualifiée d'inférieure devient l'électrode supérieure.

Le matériau de la couche active 103 est de type OTS. Par exemple, la couche active sélectrice 1012 est réalisée Ge-Sb-Se-N. D'autres matériaux tels que par exemple le Ge-Se , As-Te-Al, As-Te-Al-N, Ge-Se-Te, Ge-Se-Sb, As-Ge-Te, As-Ge-Te-Si, Si-Te, C-Te, Al-Te, B-Te, Ge-Te, ou encore en As-Ge-Se-Te pourraient être utilisés. L'épaisseur de la couche active 103, donnée à titre purement illustratif, est de l'ordre de 25 nm. Nous verrons par la suite l'effet de l'épaisseur et du choix du matériau OTS sur le fonctionnement de la matrice selon l'invention.

Le fonctionnement d'un tel commutateur 100 a déjà été décrit en référence à la figure 3. Pour rappel, le commutateur 100 doit d'abord être formé ou initialisé : pour ce faire, il suit une fois la caractéristique courant tension C1. Une fois formé, il suivra la caractéristique courant tension C2. Notons également que les tensions de forming (ou fire) et de seuil sont susceptibles de varier d'un commutateur à l'autre, même pour des commutateurs identiques structurellement. Ainsi, un type de commutateur (c'est-à-dire pour les mêmes matériaux utilisés à la fois pour la couche active et pour les électrodes, les mêmes dimensions et la même géométrie), on observe une distribution des tensions de forming et de seuil. Ces distributions sont illustrées schématiquement sur la figure 3 par les références D1 (distribution des tensions de forming ou d'initialisation) et D2 (distribution des tensions de seuil). Ces distributions peuvent par exemple prendre la forme d'une gaussienne.

Dans la matrice 100 selon l'invention, illustrée en figure 4, un premier groupe de commutateurs, les commutateurs hachurés, ont été initialisés tandis qu'un second groupe de commutateurs, les commutateurs blancs, n'ont pas été initialisés. L'état initialisé de certains commutateurs permet d'obtenir un message correspondant à la disposition des commutateurs initialisés dans la matrice. Ici, le message est un message prédéterminé et correspond à l'écriture des initiales CEA dans la matrice. Pour ce faire, on part d'une matrice 600 représentée à la figure 5 où aucune des commutateurs n'a subi de firing puis on sélectionne les commutateurs que l'on souhaite former : ces commutateurs sont ensuite formés individuellement, par exemple en adressant la bonne ligne supérieure et la bonne ligne inférieure d'un système d'adressage de type cross-bar. Ce type de matrice est particulièrement intéressante dans le cas d'applications de type « Contrôle d'intégrité » mais nous verrons par la suite que le message peut être aussi aléatoire de sorte que la matrice selon l'invention peut également être utilisée pour des applications de type PUF.

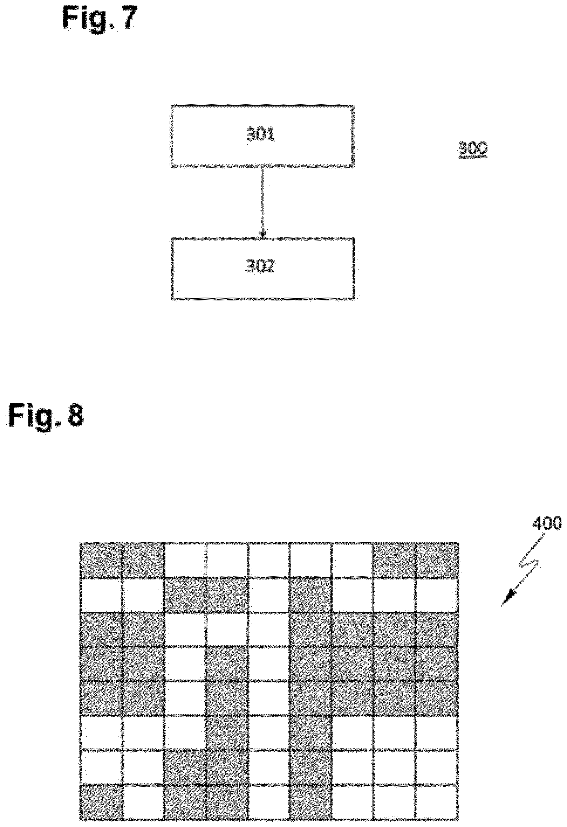

Pour résumer, le procédé d'obtention d'une matrice 100 selon l'invention consiste à écrire un message dans une matrice comprenant une pluralité de commutateurs volatils non initialisés telle que celle représentée en figure 5. Ce procédé d'écriture 300 est représenté schématiquement en figure 7.

Selon une première étape 301, on part d'une matrice où chacun des commutateurs volatils comportant une couche active réalisée dans un matériau OTS est initialement non initialisé (figure 5). Selon une étape 302, on applique une tension choisie pour initialiser un premier groupe de la pluralité de commutateurs volatils, les autres commutateurs de la pluralité de commutateurs volatils formant un second groupe n'étant pas initialisés.

Cette étape 302 peut être précédée d'une étape d'adressage des commutateurs formant le premier groupe dans le cas où l'on souhaite écrire un message prédéterminé (cas de la sélection des commutateurs hachurées de la figure 4). Une fois ces commutateurs adressés, à l'étape 302, chacune de ces commutateurs sélectionnés va se voir appliquer une tension d'initialisation : on peut par exemple appliquer à chacune des commutateurs sélectionnés une tension d'initialisation supérieure ou égale à la tension d'initialisation maximale de la distribution D1 des tensions d'initialisation. Cette tension d'initialisation n'est pas appliquée aux commutateurs du second groupe (ou a minima si une tension est appliquée, sa valeur est inférieure à la tension d'initialisation minimale des commutateurs du second groupe).

Dans le cas d'un message aléatoire, le message n'est, par définition, pas connu à l'avance. Une façon d'écrire ce message va consister à l'étape 302, à appliquer une tension à l'ensemble des commutateurs de la matrice de commutateurs non initialisés. Si l'on souhaite initialiser environ 50% des commutateurs de façon aléatoire, on peut choisir une tension d'initialisation sensiblement égale à la médiane de la distribution des tensions d'initialisation D1. On obtient alors une matrice 400 telle que celle illustrée en figure 8 où 36 commutateurs (sur les 72 de la figure 5) sont formés. On notera qu'il est possible de former moins de commutateurs en choisissant la tension de forming à appliquer selon la distribution D1 de façon à obtenir le pourcentage ad hoc de commutateurs formés.

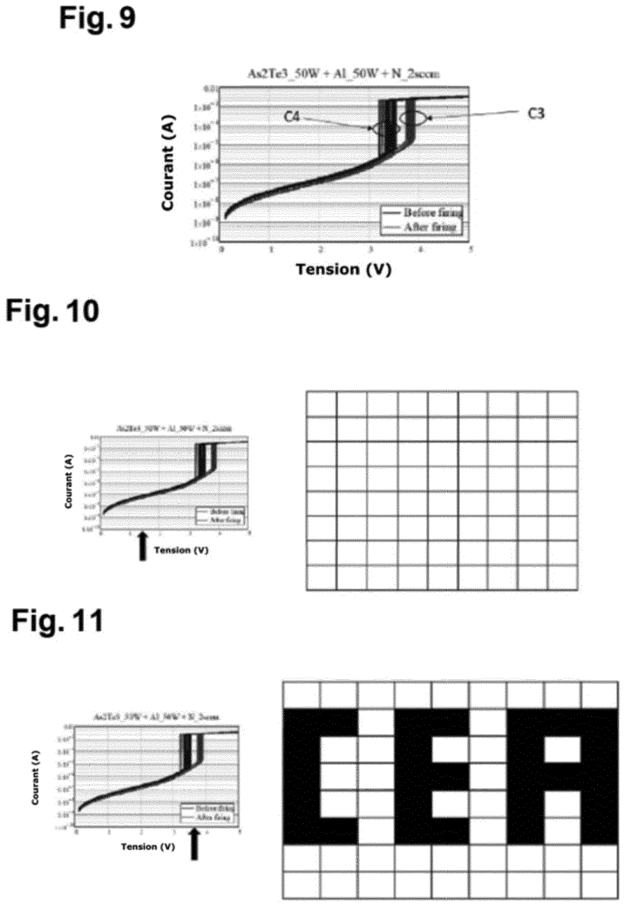

Le procédé de lecture du message de la matrice 100 selon l'invention va être illustré en référence aux figures 9 à 13.

La figure 9 représente une pluralité de caractéristiques courant tension correspondant à plusieurs commutateurs OTS au moment de l'initialisation ou forming, c'est-à-dire lors de la première utilisation (courbes C3) et après forming (courbes C4). Ces commutateurs OTS sont tous identiques et sont réalisés avec une couche active en AsTeAIN présentant une épaisseur de 75nm. On constate que la caractéristique courant tension de chaque commutateur est identique en-dessous de sa tension de seuil que le commutateur soit ou non initialisé : le choix de l'identité sous seuil des caractéristiques courant tension est avantageux dans le cas de la matrice selon l'invention pour éviter les contrastes qui pourraient apparaître au niveau du courant lors de la lecture du message. Toutefois, il est également possible de prendre des commutateurs présentant des caractéristiques sous seuil différente avant et après forming dans un mode légèrement dégradé (cas des caractéristiques de la figure 3 qui ne suivent pas sous le seuil). L'hypothèse est la suivante : on part d'une matrice 100 telle qu'illustrée en figure 4 sur laquelle un premier groupe de commutateurs a été formé de manière à écrire l'abréviation CEA.

A la figure 10, on applique une tension (dont la valeur est représentée par la flèche noire) à l'ensemble des commutateurs de la matrice. Cette tension est inférieure aux tensions de seuil de l'ensemble des commutateurs de sorte qu'aucun des commutateurs n'est dans l'état ON, tous les commutateurs restant dans l'état hautement résistif (représenté par les commutateurs sur fond blanc).

A la figure 11, on applique une tension (dont la valeur est représentée par la flèche noire) à l'ensemble des commutateurs de la matrice. Cette tension de lecture est comprise entre la tension maximale de la distribution des tensions de seuil des commutateurs présents dans la matrice et la tension minimale de la distribution des tensions d'initialisation des commutateurs présents dans la matrice. Ainsi, les commutateurs qui n'étaient pas initialisés sont lus avec une résistance très élevée à cette tension (même si la tension est supérieure à leur tension de seuil) : seules les commutateurs initialisés ou formés (représentés sous forme hachurée à la figure 4) voient leur résistance basculer de l'état OFF à l'état ON de sorte que le message CEA peut être lu en discriminant entre les commutateurs OTS ayant une résistance élevée et ceux étant à l'état ON.

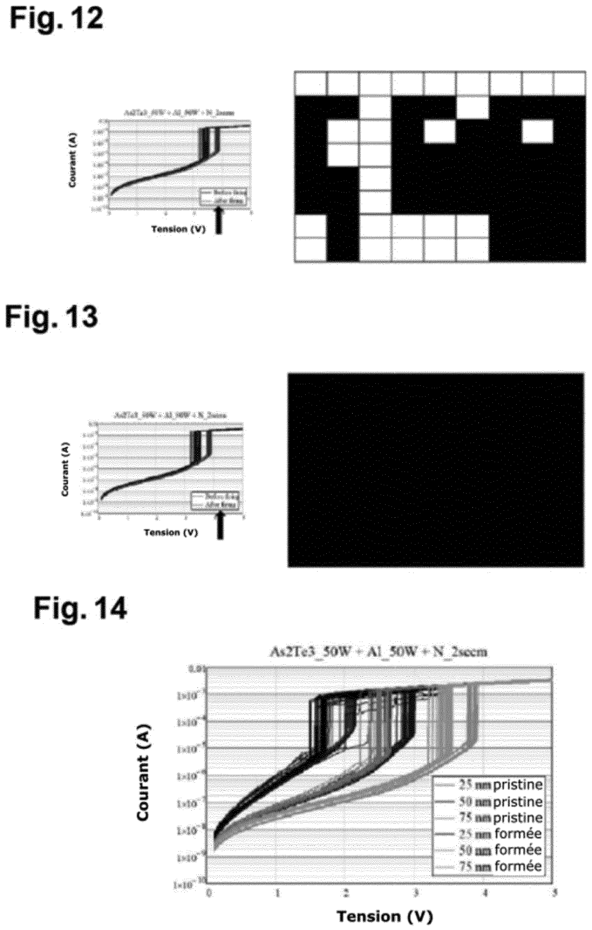

A la figure 12, on applique une tension (dont la valeur est représentée par la flèche noire) à l'ensemble des commutateurs de la matrice. Cette tension est située au sein de la distribution des tensions d'initialisation des commutateurs présents dans la matrice. Ainsi, certains commutateurs qui n'étaient pas initialisés à la figure 4 sont formés et voient leur résistance basculer de l'état OFF à l'état ON en plus des commutateurs déjà initialisés à la figure 4 de sorte que le message CEA est rendu illisible de façon irréversible.

A la figure 13, on applique une tension (dont la valeur est représentée par la flèche noire) à l'ensemble des commutateurs de la matrice. Cette tension est supérieure à la tension maximale de la distribution des tensions d'initialisation de sorte que tous les commutateurs de la matrice sont formés, rendant le message totalement illisible.

Ainsi pour lire correctement le message sans l'endommager, il convient de se placer à une tension de lecture bien déterminée située sur une plage de tensions donnée dépendant des distributions de tensions de seuil et de forming et donc de l'ensemble des caractéristiques des commutateurs OTS utilisés telles que le matériau OTS, les matériaux des électrodes, la géométrie et les dimensions des couches et notamment l'épaisseur des couches. La lecture d'une matrice comprenant un message aléatoire telle que celle de la figure 8, notamment dans le cadre d'une application PUF se fait de façon semblable. On notera qu'il est également possible de faire du contrôle d'intégrité avec une application PUF : typiquement, on sait que 50% des commutateurs ont été formés. Si on se rend compte en lisant les commutateurs que le pourcentage de commutateurs formés a notablement changé, cela peut signifier que l'intégrité du dispositif est remise en cause.

Il est également particulièrement avantageux que les distributions des tensions de seuil et de forming des commutateurs présents dans la matrice soient disjointes (cas des distributions C3 et C4 de la figure 9 qui ne présentent aucune tension en commun). A ce titre, on peut constater que l'épaisseur de la couche active OTS peut sensiblement modifier les distributions de tensions de seuil et de forming. A titre illustratif, la figure 14 représente différentes distributions de caractéristiques courant tension avant et après initialisation pour des commutateurs OTS réalisés avec le même matériau AsTeAIN de couche active mais pour trois épaisseurs différentes : 25nm, 50nm et 75nm. On constate que les distributions de tension de seuil et de forming sont bien disjointes pour une épaisseur de 75nm mais qu'elles présentent des points communs pour des épaisseurs de 25nm et 50nm augmentant le risque d'erreur lors de la lecture des matrices selon l'invention. Il est donc particulièrement avantageux de choisir l'épaisseur de la couche active des commutateurs OTS afin que les distributions des tensions de seuil et d'initialisation soient bien disjointes.

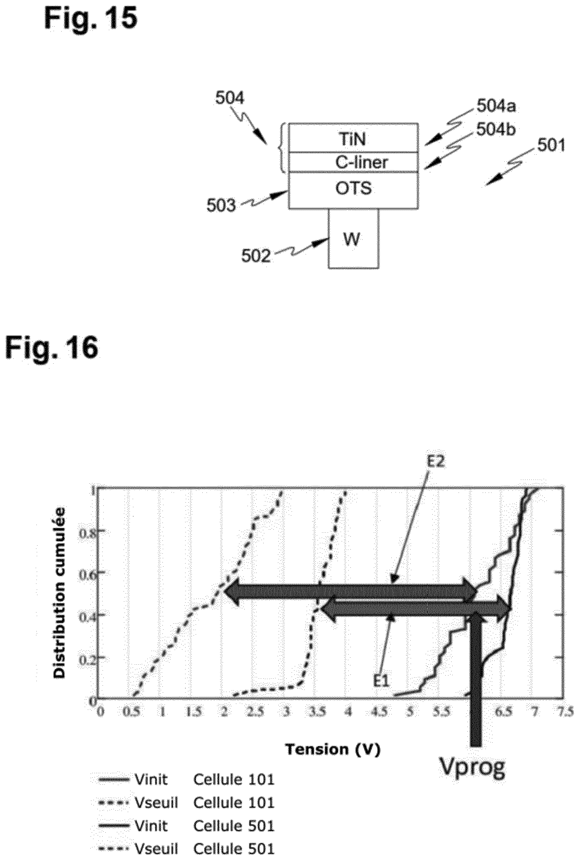

Un autre exemple de commutateur 501 utilisable dans la matrice selon l'invention est représenté en figure 15. La commutateur 501 comporte :
- une couche de matériau conducteur en tungstène W formant l'électrode inférieure 502 ;
- une couche active réalisée dans un matériau actif OTS 503, ici le GeSbSeN;
- une électrode supérieure 504 incluant :
   - une couche de matériau conducteur en TiN 504a
   - une couche de C dite aussi C-liner 504b en contact avec la couche active 503.

La commutateur 501 se différencie donc du commutateur 101 par l'ajout du liner en carbone C 504b.

On utilise la couche de C 540b notamment lorsqu'on utilise une couche de matériau conducteur 540a qui diffuse dans la couche active, par exemple le Ti dans la couche 504a de TiN peut diffuser dans la couche OTS 503. L'avantage du carbone est qu'il est inerte avec le matériau OTS et qu'il n'y diffuse pas. Ainsi, la couche de C joue le rôle de barrière de diffusion. Le carbone n'est qu'un exemple illustratif et d'autres matériaux pourraient être utilisés comme barrière de diffusion. Ainsi, des couches à base de W, Ta ou de Mo utilisé comme matériau inerte pourraient être envisagés pour les électrodes ou pour la réalisation de la barrière de diffusion.

La figure 16 illustre l'effet de l'ajout de la couche de C 504b sur les distributions de tension entre le commutateur 101 et le commutateur 501. La figure 16 représente la distribution cumulée (i.e. le pourcentage de commutateurs concernés dans la matrice selon l'invention) en fonction de la tension de seuil et d'initialisation (dite aussi de forming ou de fire) pour les deux types de commutateurs 101 et 501. On constate sur cette figure que l'ajout de la couche de C a un impact sur la forme des distributions et sur l'écart entre celles-ci. On observe un écart E1 plus faible entre les médianes des distributions de tension de seuil et d'initialisation dans le cas de commutateurs 501 avec l'ajout d'une couche de C que l'écart E2 dans le cas de commutateurs 101. Cet écart plus faible a un effet immédiat sur la difficulté d'accès au message stocké dans la matrice selon l'invention. En effet, il sera beaucoup plus difficile de trouver la tension de lecture appropriée lorsque l'écart entre les distributions est réduit sans prendre le risque d'effacer et de réduire l'intégrité du message. Ainsi, pour des applications nécessitant un fort degré de sécurité, l'ajout d'une couche de C (ou de façon plus générale d'une couche de matériau inerte par rapport à la couche active OTS) dans les commutateurs peut présenter un intérêt. A contrario, le choix de la tension de forming Vprog permettant notamment de former aléatoirement 50% des commutateurs sera plus facile dans le cas des commutateurs 101 sans couche de C. En effet, la pente de la distribution étant plus importante, la précision du nombre de commutateurs formés sera plus élevée. Il y a donc un arbitrage à faire en fonction du type d'applications visées.

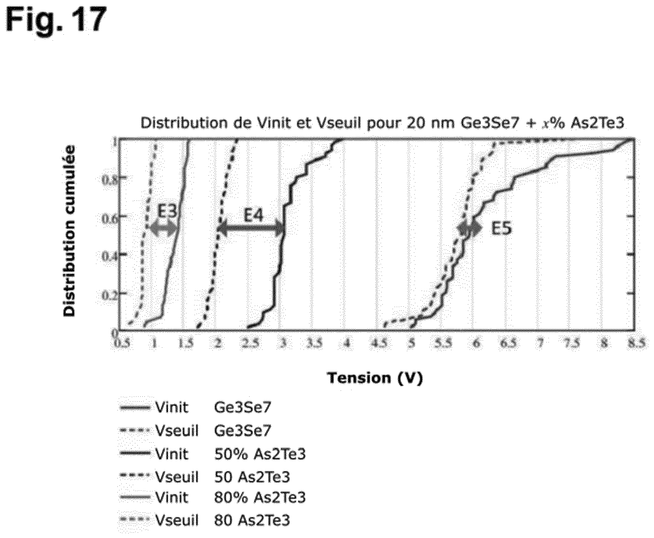

Comme mentionné plus haut, le type de matériau peut également avoir un effet sur les distributions des tensions de seuil et de forming. Ce phénomène est illustré sur la figure 17 qui montre la distribution cumulée (i.e. le pourcentage de commutateurs concernés dans la matrice selon l'invention) en fonction de la tension de seuil et d'initialisation (dite aussi de forming ou de firing) pour trois matériaux différents utilisés pour la couche active OTS avec une même épaisseur de 25 nm.:
- alliage Ge₃Se₇
- alliage Ge₃S₇ + 50% de AsSTe₃
- alliage Ge₃S₇ + 80% de AsSTe₃
On constate que l'écart E3, E4 et E5 entre les distributions des tensions de seuil et d'initialisation varie sensiblement selon le matériau utilisé avec un écart E5 beaucoup plus faible pour le matériau Ge₃Se₇. Ainsi, en fonction de l'application visée et du degré de sécurité souhaité, le choix du matériau OTS aura donc une influence importante.

D'autres paramètres peuvent également permettre de régler le fonctionnement de la matrice selon l'invention. Ainsi, certains matériaux OTS sont plus ou moins sensibles à la température qui peut modifier considérablement leur comportement électrique. Le choix d'un matériau OTS peu sensible à la température peut être intéressant dans le cas où l'on veut intégrer la puce formant la matrice selon l'invention dans un boitier nécessitant des soudures à haute température (typiquement de l'ordre de 260°C) : les matériaux à base de GeSe sont des bons exemples de matériaux faiblement sensibles à la température.

## Revendications

1. Matrice (100 ; 400; 600) comprenant une pluralité de commutateurs (101 ; 501) volatils, chacun desdits commutateurs volatils comportant une couche active (103 ;503) réalisée dans un matériau OTS, la pluralité de commutateurs volatils étant divisée en deux groupes de manière à former un message,
- chacun des commutateurs volatils du premier groupe ayant été préalablement initialisé ou programmé au moyen d'une tension d'initialisation ou de programmation,
- aucun des commutateurs volatils du deuxième groupe n'ayant été préalablement initialisé ou programmé au moyen d'une tension d'initialisation ou de programmation,
- ledit message étant formé par les états initialisés ou non initialisés de chacun des commutateurs de la matrice.

2. Matrice (100 ; 400 ; 600) selon la revendication 1, **caractérisée en ce que** tous les commutateurs (101 ; 501) volatils de la matrice sont structurellement identiques.

3. Matrice (100; 400 ; 600) selon l'une des revendications précédentes **caractérisée en ce que** chaque commutateur (101 ; 501) comprend une première électrode (104 ; 504), une deuxième électrode (102 ; 502), la couche active (106 ;503) étant localisée entre la première électrode et la deuxième électrode.

4. Matrice (100; 400; 600) selon la revendication précédente **caractérisée en ce que** la première électrode (504) comporte une couche de carbone (504b) en contact avec la couche active (503).

5. Matrice (100; 400 ; 600) selon l'une des revendications précédentes **caractérisée en ce que** la pluralité de commutateurs (101 ; 501) est configurée de sorte que la distribution des tensions de seuil des commutateurs présents dans la matrice et la distribution des tensions d'initialisation des commutateurs présents dans la matrice ne présentent aucune tension commune.

6. Matrice (100; 400 ; 600) selon l'une des revendications précédentes **caractérisée en ce que** la pluralité de commutateurs (101 ; 501) est configurée de sorte que la caractéristique courant-tension de chaque commutateur soit identique en-dessous de sa tension de seuil que le commutateur soit ou non initialisé.

7. Matrice (100; 400 ; 600) selon l'une des revendications précédentes **caractérisée en ce que** la tension de lecture utilisée pour lire le message se trouve entre la tension maximale de la distribution des tensions de seuil des commutateurs (101 ; 501) présents dans la matrice et la tension minimale de la distribution des tensions d'initialisation des commutateurs présents dans la matrice.

8. Matrice (100; 400 ; 600) selon l'une des revendications précédentes **caractérisé en ce que** ledit message est un message aléatoire ou prédéterminé.

9. Procédé (300) d'écriture d'un message dans une matrice (100 ; 400 ; 600) comprenant une pluralité de commutateurs (101 ;501) volatils, chacun desdits commutateurs volatils comportant une couche active (103 ; 503) réalisée dans un matériau OTS et étant initialement non initialisée ou programmée, ledit procédé comportant l'application (302) d'une tension choisie pour initialiser ou programmer un premier groupe de la pluralité de commutateurs volatils, les autres commutateurs de la pluralité de commutateurs volatils formant un second groupe n'étant pas initialisées ou programmées.

10. Procédé (300) d'écriture selon la revendication précédente **caractérisé en ce que** ledit message est un message prédéterminé, le procédé comportant les étapes suivantes :
- sélection des commutateurs (101 ; 501) formant le premier groupe ;
- application d'une tension d'initialisation sur chacun des commutateurs du premier groupe de manière à initialiser chacun d'entre eux, sans appliquer de tension d'initialisation sur les autres commutateurs formant le second groupe.

11. Procédé (300) d'écriture selon la revendication 9 **caractérisé en ce que** ledit message est un message aléatoire, non connu à l'avance, le procédé comportant une étape d'application d'une tension à chacun des commutateurs (101 ; 501) de la pluralité de commutateurs, la valeur de la tension étant choisie pour initialiser un pourcentage donné et différent de 100% de commutateurs parmi la pluralité de commutateurs.

12. Procédé d'écriture selon la revendication 11 **caractérisé en ce que** la valeur de la tension appliquée correspond sensiblement à la valeur médiane de la distribution des tensions d'initialisation de la pluralité de commutateurs.

13. Procédé de lecture du message présent dans une matrice (100 ; 400 ; 600) selon l'une quelconque des revendications 1 à 8 comportant une étape d'application d'une tension de lecture à chacun des commutateurs (101 ; 501), ladite tension de lecture étant comprise entre la tension maximale de la distribution des tensions de seuil des commutateurs présents dans la matrice et la tension minimale de la distribution des tensions d'initialisation des commutateurs présents dans la matrice.

## Patentansprüche

1. Matrix (100; 400; 600), die eine Vielzahl von flüchtigen Schaltern (101; 501) umfasst, wobei jeder der flüchtigen Schalter eine aktive Schicht (103; 503) aufweist, die aus einem OTS-Material hergestellt ist, wobei die Vielzahl von flüchtigen Schaltern in zwei Gruppen unterteilt ist, um eine Nachricht zu bilden,
- wobei jeder der flüchtigen Schalter der ersten Gruppe zuvor mithilfe einer Initialisierungs- oder Programmierspannung initialisiert oder programmiert worden ist,
- keiner der flüchtigen Schalter der zweiten Gruppe zuvor mittels einer Initialisierungs- oder Programmierspannung initialisiert oder programmiert wurde,
- wobei die Nachricht durch die initialisierten oder nicht initialisierten Zustände jedes der Schalter in der Matrix gebildet wird.

2. Matrix (100; 400; 600) nach Anspruch 1, **dadurch gekennzeichnet, dass** alle flüchtigen Schalter (101; 501) in der Matrix strukturell identisch sind.

3. Matrix (100; 400; 600) nach einem der vorhergehenden Ansprüche, **dadurch gekennzeichnet, dass** jeder Schalter (101; 501) eine erste Elektrode (104; 504) und eine zweite Elektrode (102; 502) umfasst, wobei die aktive Schicht (106; 503) zwischen der ersten Elektrode und der zweiten Elektrode lokalisiert ist.

4. Matrix (100; 400; 600) nach dem vorhergehenden Anspruch, **dadurch gekennzeichnet, dass** die erste Elektrode (504) eine Kohlenstoffschicht (504b) aufweist, die mit der aktiven Schicht (503) in Kontakt steht.

5. Matrix (100; 400; 600) nach einem der vorhergehenden Ansprüche, **dadurch gekennzeichnet, dass** die Vielzahl von Schaltern (101; 501) so ausgeführt ist, dass die Verteilung der Schwellenspannungen der in der Matrix vorhandenen Schalter und die Verteilung der Initialisierungsspannungen der in der Matrix vorhandenen Schalter keine gemeinsamen Spannungen aufweisen.

6. Matrix (100; 400; 600) nach einem der vorhergehenden Ansprüche, **dadurch gekennzeichnet, dass** die Vielzahl von Schaltern (101; 501) so ausgeführt ist, dass die Strom-Spannungs-Kennlinie jedes Schalters unterhalb seiner Schwellenspannung identisch ist, unabhängig davon, ob der Schalter initialisiert ist oder nicht.

7. Matrix (100; 400; 600) nach einem der vorhergehenden Ansprüche, **dadurch gekennzeichnet, dass** die Lesespannung, die zum Lesen der Nachricht verwendet wird, zwischen der maximalen Spannung der Verteilung der Schwellenspannungen der in der Matrix vorhandenen Schalter (101; 501) und der minimalen Spannung der Verteilung der Initialisierungsspannungen der in der Matrix vorhandenen Schalter liegt.

8. Matrix (100; 400; 600) nach einem der vorhergehenden Ansprüche, **dadurch gekennzeichnet, dass** die Nachricht eine zufällige oder vorbestimmte Nachricht ist.

9. Verfahren (300) zum Schreiben einer Nachricht in einer Matrix (100; 400; 600) mit einer Vielzahl von flüchtigen Schaltern (101; 501), wobei jeder der flüchtigen Schalter eine aktive Schicht (103; 503) aus einem OTS-Material aufweist und anfänglich nicht initialisiert oder programmiert ist, wobei das Verfahren das Anlegen (302) einer Spannung umfasst, die ausgewählt wird, um eine erste Gruppe der Vielzahl von flüchtigen Schaltern zu initialisieren oder zu programmieren, wobei die anderen Schalter der Vielzahl von flüchtigen Schaltern, die eine zweite Gruppe bilden, nicht initialisiert oder programmiert sind.

10. Schreibverfahren (300) nach dem vorherigen Anspruch, **dadurch gekennzeichnet, dass** die Nachricht eine vorbestimmte Nachricht ist, wobei das Verfahren die folgenden Schritte umfasst:
- Auswählen der Schalter (101; 501), die die erste Gruppe bilden;
- Anlegen einer Initialisierungsspannung an jeden der Schalter der ersten Gruppe, um so jeden von ihnen zu initialisieren, ohne eine Initialisierungsspannung an die anderen Schalter, die die zweite Gruppe bilden, anzulegen.

11. Schreibverfahren (300) nach Anspruch 9, **dadurch gekennzeichnet, dass** die Nachricht eine zufällige, nicht im Voraus bekannte Nachricht ist, wobei das Verfahren einen Schritt des Anlegens einer Spannung an jeden der Schalter (101; 501) der Vielzahl von Schaltern umfasst, wobei der Wert der Spannung ausgewählt wird, um einen gegebenen und von 100% verschiedenen Prozentsatz der Schalter unter der Vielzahl von Schaltern zu initialisieren.

12. Schreibverfahren nach Anspruch 11, **dadurch gekennzeichnet, dass** der Wert der angelegten Spannung im Wesentlichen dem Medianwert der Verteilung der Initialisierungsspannungen der Vielzahl von Schaltern entspricht.

13. Leseverfahren für eine Nachricht in einer Matrix (100; 400; 600) nach einem der Ansprüche 1 bis 8, das einen Schritt des Anlegens einer Lesespannung an jeden der Schalter (101; 501) umfasst, wobei die Lesespannung zwischen der maximalen Spannung der Verteilung der Schwellenspannungen der in der Matrix vorhandenen Schalter und der minimalen Spannung der Verteilung der Initialisierungsspannungen der in der Matrix vorhandenen Schalter liegt.

## Claims

1. Matrix (100 ; 400 ; 600) comprising a plurality of volatile switches (101 ; 501), each of said volatile switches comprising an active layer (103 ; 503) made of an OTS material, the plurality of volatile switches being divided into two groups in such a way as to form a message,
- each of the volatile switches of the first group having been initialized beforehand or programmed by means of an initialization voltage or a programming voltage,
- none of the volatile switches of the second group having been initialized beforehand or programmed by means of an initialization voltage or a programming voltage,
- said message being formed by the initialized or non-initialized states of each of the switches of the matrix.

2. Matrix (100 ; 400 ; 600) according to claim 1, **characterised in that** all of the volatile switches (101 ; 501) of the matrix are structurally identical.

3. Matrix (100 ; 400 ; 600) according to one of the preceding claims, **characterised in that** each switch (101 ; 501) comprises a first electrode (104 ; 504), a second electrode (102 ; 502), the active layer (106 ; 503) being located between the first electrode and the second electrode.

4. Matrix (100 ; 400 ; 600) according to the preceding claim, **characterised in that** the first electrode (504) comprises a layer of carbon (504b) in contact with the active layer (503).

5. Matrix (100 ; 400 ; 600) according to one of the preceding claims, **characterised in that** the plurality of switches (101 ; 501) is configured in such a way that the distribution of the threshold voltages of the switches present in the matrix and the distribution of the initialization voltages of the switches present in the matrix do not have any common voltage.

6. Matrix (100 ; 400 ; 600) according to one of the preceding claims, **characterised in that** the plurality of switches (101 ; 501) is configured in such a way that the current-voltage characteristic of each switch is identical below its threshold voltage whether the switch is initialized or not.

7. Matrix (100 ; 400 ; 600) according to one of the preceding claims, **characterised in that** the reading voltage used to read the message lies between the maximum voltage of the distribution of the threshold voltages of the switches (101 ; 501) present in the matrix and the minimum voltage of the distribution of the initialization voltages of the switches present in the matrix.

8. Matrix (100 ; 400 ; 600) according to one of the preceding claims, **characterised in that** said message is a random or predetermined message.

9. Method (300) for writing a message in a matrix comprising a plurality of volatile switches (100; 400; 600), each of said volatile switches (101 ; 501) comprising an active layer (103 ; 503) made of an OTS material and not being initially initialized or programmed, said method comprising the application (302) of a voltage chosen to initialize or program a first group of the plurality of volatile switches, the other switches of the plurality of volatile switches forming a second group not being initialized or programmed.

10. Method (300) for writing according to the preceding claim, **characterised in that** said message is a predetermined message, the method comprising the following steps:
- selection of the switches (101 ; 501) forming the first group;
- application of an initialization voltage to each of the switches of the first group in such a way as to initialize each among them, without applying an initialization voltage to the other switches forming the second group.

11. Method (300) for writing according to claim 9, **characterised in that** said message is a random message, not known in advance, the method comprising a step of application of a voltage to each of the switches of the plurality of switches (101 ; 501), the voltage value being chosen to initialize a given percentage and different from 100% of switches among the plurality of switches.

12. Method for writing according to claim 11, **characterised in that** the value of the applied voltage corresponds substantially to the median value of the distribution of the initialization voltages of the plurality of switches.

13. Method for reading the message present in a matrix (100 ; 400 ; 600) according to any of claims 1 to 8 comprising a step of application of a reading voltage to each of the switches (101 ; 501), said reading voltage being comprised between the maximum voltage of the distribution of the threshold voltages of the switches present in the matrix and the minimum voltage of the distribution of the initialization voltages of the switches present in the matrix.
